# EUROPEAN PATENT APPLICATION

(11) **EP 3 086 232 A2**
(43) Date of publication of application: **26.10.2016**
(21) Application number: 15200738.1
(22) Date of filing: 17.12.2015
(51) Int. Cl.: G06F 11/14, H05K 5/00, H05K 5/02, G06F 13/40

(54) **PLUG CONNECTOR, CABLE ASSEMBLY, AND DATA BACKUP METHOD AND DATA RECOVERY METHOD BY USING THE CABLE ASSEMBLY WITH STORAGE FUNCTION**

(30) Priority: 02.04.2015 TW 104205093; 24.06.2015 TW 104120298
(71) Applicant: PhotoFast Co. Ltd., Taipei City 100 (TW)
(72) Inventor: Wang, Warren, 100 Taipei City (TW)
(74) Representative: Straus, Alexander

(57) **Abstract**

A data backup method and a data recovery method by using a cable assembly with storage function are disclosed in the present invention. When an electronic device is connected with a cable assembly, the data backup or data recovery can be processed. Since the cable assembly is required when the electronic device needs to be charged or be connected with a computer, the user will carry the cable assembly all the time and the data backup and the data recovery can be executed at anytime and anywhere. The data didn't back up for a long time can be avoided and the backup data is very different from the data within the electronic device can be avoided. The convenience of the data backup and the data recovery is increased.

## Description

### CROSS-REFERENCE TO RELATED APPLICATIONS

This application claims the benefit of Taiwan patent application No. 104120298, filed on June 24, 2015, the disclosure of which is incorporated herein in its entirety by reference.

### BACKGROUND OF THE INVENTION

### 1. Field of the Invention

The present invention relates to a plug connector of a cable assembly and a data backup method and a data recovery method, and more particularly to implement a cable assembly with storage function to perform the data backup method and the data recovery method.

### 2. Description of Related Art

Most people in today's life like to use electronic devices and usually use the electronic devices for memorizing things. For example, the electronic devices are used to record photos, calendar or contact data. However, memory storage volume included in the electronic devices is limited. When more and more data is required to be stored, the memory storage volume in the electronic device will run out very soon. Therefore, the data saved in the electronic devices is required to be reorganized, and unnecessary data should be deleted or moved to different storage devices.

In addition, as long as the data is stored in the memory of the electronic device, the user will lost those data when the electronic device is missed or the memory of the electronic device is damaged. Therefore, the user needs to record the data again. During a recording procedure, some of the data will be missed to cause inconvenience for the user and some of the data, such as photo and so on, cannot be recovered. If the user lost those data, those data cannot be retrieved. The conventional technology is to connect the electronic device with a computer and the data in the electronic device can be stored in the computer. Those data is stored in both of the electronic device and the computer to avoid the inconvenience when the electronic device is missed or damaged.

However, the conventional technique has to connect the electronic device to the computer to perform the data backup function. If the user does not have a computer, the data cannot be backed up immediately. Moreover, if the user didn't connect the electronic device with the computer for a long time, the data created from the electronic device of the user during this period of time cannot be backed up to the computer. Therefore, the data stored in the computer is different from the data stored in the electronic device. When the electronic device is not connected to the computer for a longer time, the difference between the data in the computer and the electronic device is greater and greater. Therefore, the data of the electronic device is stored in the computer but the data is not updated for a long time. When the user lost the electronic device, only the old data saved long time ago can be retrieved from the computer and the data saved in the electronic device recently is not saved in the computer. The lost of the data is still happened and the inconvenience for the user is caused.

### SUMMARY OF THE INVENTION

Since the conventional data backup technique to store data in the computer is not convenient, an objective of the present invention is to provide a data backup method and a data recovery method by using a cable assembly with storage function. The user can back up data frequently and an inconvenient of a data lost of an electronic device can be reduced.

In order to achieve the aforementioned objective, a data backup method by using a cable assembly with storage function executed by an electronic device comprises steps of:
determining whether a backup signal is received and a cable with storage function is connected, wherein the cable with storage function is a cable having a flash memory module;
executing a backup procedure when the backup signal is received and the cable assembly is connected;
transmitting data saved in the electronic device to store in the cable assembly when the backup procedure is executed;
confirming whether the data is stored in the cable with storage function; and
ending the backup procedure when the data is stored in the cable assembly with storage function.

Since the cable assembly can be used for the electronic device to charge or transfer the data by connecting with the computer, the user will carry the cable assembly all the time. The present invention can implement the cable assembly to back up the data when the electronic device uses the cable assembly to charge. Therefore, the backup data can be updated frequently, and the inconvenient of the lost of the data of the electronic device can be reduced.

In addition, the data recovery method by using the cable assembly with storage function in the present invention is executed by an electronic device, and the method includes steps of:
determining whether a recovery signal is received and a cable assembly with storage function is connected, wherein the cable assembly with storage function is a cable assembly having a flash memory module;
executing a recover procedure when the recovery signal is received and the cable assembly is connected;
choosing one data in the cable assembly with storage function to transmit to the electronic device when the recover procedure is executed;
confirming whether the data is stored in the electronic device; and
ending the recover procedure when the data is stored in the electronic device.

When the electronic device of the user is lost and replaced with a new electronic device or the memory of the electronic device is damaged to cause the lost of the data, the user can implement the cable assembly to recover the data saved in the memory unit of the cable assembly back to the electronic device. The recording data within the electronic device can be recovered and the user is not requested to input the data again. Therefore, the convenience is increased.

One object of the present invention is to provide a plug connector. The plug connector includes a circuit board assembly, a memory module and a shielded enclosure. The circuit board assembly includes a circuit board and a first terminal group. The first terminal group includes a plurality of first conductive terminals to transmit electric power, and the first terminal group is disposed on the top surface of the circuit board. The memory connector is disposed on the bottom surface of the circuit board. The memory module is assembled on the memory connector. The shielded enclosure includes an accommodating space. Wherein the accommodating space contains the circuit board assembly and the memory module, and a cable assembly consists of the plug connector, a device connector and a cable body.

In the aforementioned plug connector, wherein the memory module is assembled at the memory connector in non-removable mode.

In the aforementioned plug connector, wherein the memory module is assembled at the memory connector in removable mode.

In the aforementioned plug connector, wherein the memory connector includes a fixed support and a plurality of signal terminals, the fixed support is fixed at the bottom surface of the circuit board, and a assembly groove on the bottom surface of the fixed support contains the memory module, and the signal terminals is fixed in the fixed support; wherein a plurality of metal contacts on top surface of the memory module is electrically connected to the signal terminals respectively.

In the aforementioned plug connector, wherein the circuit board assembly further includes a second terminal group and the second terminal group including a plurality of second conductive terminals is disposed on the top surface of the circuit board.

In the aforementioned plug connector, wherein the protective shell includes a cavity in order to contain the shielded enclosure.

In the aforementioned plug connector, wherein the plug connector meets universal serial bus 2.0 standards.

In the aforementioned plug connector, wherein the plug connector meets universal serial bus 3.0 standards.

One object of the present invention is to provide a cable assembly. The cable assembly includes a plug connector, a device connector and a cable body. The plug connector includes a circuit board assembly, a memory module and a shielded enclosure. The circuit board assembly includes a circuit board, a first terminal group and a memory connector. The first terminal group includes a plurality of first conductive terminals to transmit electric power, and the first terminal group is disposed on the top surface of the circuit board.The memory connector is disposed on the bottom surface of the circuit board. The memory module is assembled on the memory connector. The shielded enclosure includes an accommodating space. The accommodating space contains the circuit board assembly and the memory module. Addition, the cable body is connected between the plug connector and the device connector.

### BRIEF DESCRIPTION OF THE DRAWINGS

FIG. 1 is a flow chart of a data backup method by using a cable assembly with storage function in a preferred embodiment of the present invention;
FIG. 2 is a schematic view of a connection between an electronic device and a cable assembly with storage function;
FIG. 3A -FIG. 3D are schematic views of a display screen of the electronic device showing the data backup method is performed by the cable assembly with storage function;
FIG. 4 is a flow chart of a data recovery method by using the cable assembly with storage function in the preferred embodiment of the present invention; and
FIG. 5A - FIG. 5E are schematic views of the display screen of the electronic device showing the data recovery method is performed by the cable assembly with storage function.
FIG. 6 is a perspective view of a plug connector of the present invention;
FIG. 7 is another perspective view of the plug connector of the present invention;
FIG. 8 is an exploded view of the plug connector of the present invention;
FIG. 9 is another exploded view of the plug connector of the present invention;
FIG. 10 is a partial sectional view of the plug connector of the present invention;

### DETAILED DESCRIPTION OF THE PREFERRED EMBODIMENT

These and other aspects of the embodiments herein will be better appreciated and understood when considered in conjunction with the following description and the accompanying drawings.

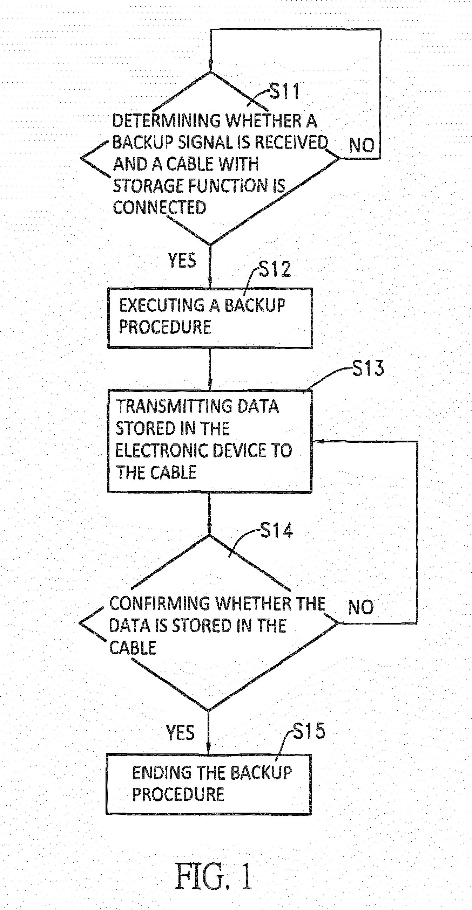

With reference to FIG. 1, a data backup method and a data recovery method by using a cable assembly with storage function is disclosed in the present invention. The data backup method performed in the cable assembly with storage function is executed by an electronic device. The data backup method includes the following steps:
determining whether a backup signal is received and a cable assembly with storage function is connected (S11);
executing a backup procedure when the backup signal is received and the cable assembly is connected (S12);
transmitting data stored in the electronic device to the cable assembly when the backup procedure is executed, such that the cable assembly stores the data transmitted from the electronic device (S 13);
confirming whether the data of the electronic device is completely transmitted to and stored in the cable assembly (S 14);
ending the backup procedure when the data of the electronic device is completely transmitted to and stored in the cable assembly (S15).

The cable assembly with storage function is a cable assembly having a flash memory module for data storing. Two ends of the cable assembly are connectors. One of the connectors is used to be connected with an electronic device, and the other connector is used to be connected with a computer or a charger. The present invention is to connect the cable assembly with the electronic device and the data within the electronic device can be backed up. When the electronic device needs to be charged or connected to a computer to transfer the data to the computer, the cable assembly can be connected to the electronic device with the charger or the computer. Therefore, users have to carry the cable assembly all the time. The present invention can back up the data in the cable when the electronic device is charged by using the cable assembly. Alternatively, when the electronic device is connected with the computer by the cable assembly, the data can be backed up in the cable assembly to update the backup data frequently and the inconvenience of the data lost in the electronic device can be reduced.

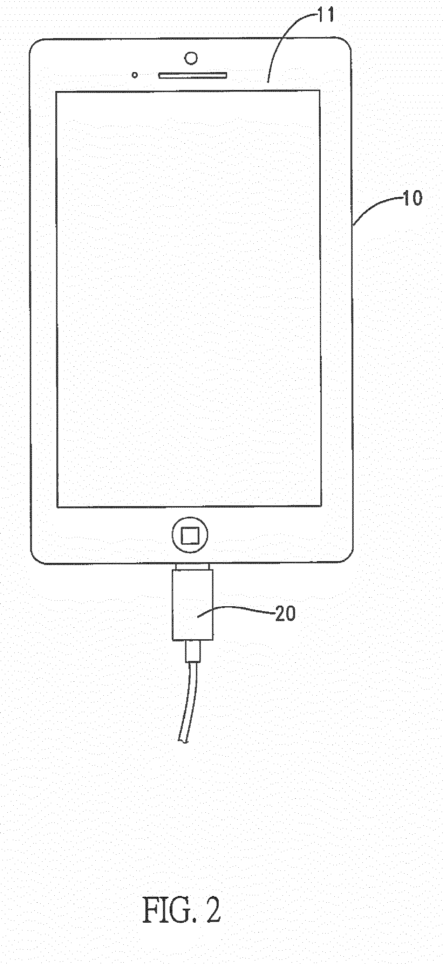

With reference to FIG. 2, when the present invention performs data backup, the electronic device 10 is connected with the cable assembly 20 and the electronic device 10 executes an application.

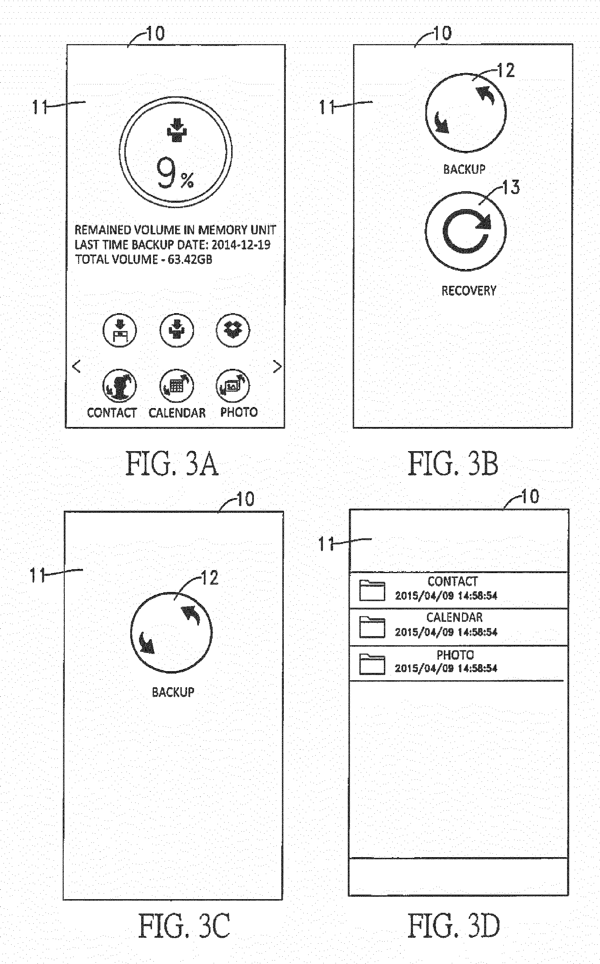

With reference to FIG. 3A, when the electronic device 10 executes the application, a display screen 11 of the electronic device shows a remained volume of the storage in the cable assembly 20 for electronic device 10 to back up data. The application provides many different kinds of backup functions for the user to choose. For example, the user can choose to back up the data related to contact data, calendar, photo, or any combinations thereof. In other words, the data can be contact data, calendar data, photo data, or any combinations thereof. In the preferred embodiment, the user chooses to back up all of the data.

With reference to FIG. 3B, when the user chooses to back up all of the data, the display screen 11 of the electronic device 10 shows a backup icon 12 and a recover icon 13 for the user to choose which the data within the electronic device will be backed up in the cable assembly or the data within the cable assembly will be transferred to be recovered in the electronic device.

With reference to FIG. 3C, when the user chooses the backup icon 12, the electronic device 10 receives a backup signal generated at the time when the user choosing the backup icon and the electronic device 10 connected with the cable assembly 20 (step S11). When the electronic device 10 receives the backup signal and the electronic device 10 is confirmed to be connected with the cable assembly 20, the backup procedure can be started to be executed (step S12). When the backup procedure is executed, the electronic device will transfer the data within the electronic device 10 to the cable assembly 20 to back up (step S13). When the data within the electronic device 10 is transferred to the cable assembly 20, the electronic device 10 confirms whether the data is stored in the cable 20. When the data is stored in the cable assembly 20, the backup procedure will be ended (step S 14). When the cable assembly 20 storing the data is not finished, the step S 13 will be executed one more time.

With reference to FIG. 3D, when the backup procedure is ended, the electronic device shows the data stored in a memory unit of the cable assembly 20 for the user to review. In the preferred embodiment, since the user chooses the function to back up all of the data, the display screen in FIG. 3D shows that the backup data includes the contact data, the calendar and the photo.

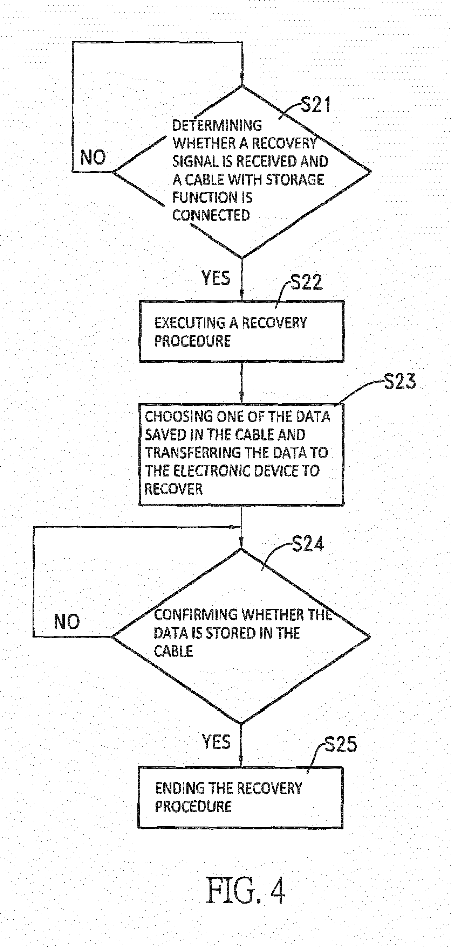

With reference to FIG. 4, the data recover method in the cable assembly with storage function is executed by the electronic device 10 and the data recovery method includes the following steps:
determining whether a recovery signal is received and a cable assembly with storage function is connected (S21);
executing a recover procedure when the recovery signal is received and the cable assembly is connected (S22);
choosing one data in the cable assembly to transmit the data to the electronic device when the recover procedure is executed (S23);
confirming whether the data is completely stored in the electronic device (S24);
ending the recover procedure when the data is completely stored in the electronic device (S25).

When the electronic device 10 of the user is lost and replaced with a new electronic device or the flash memory of the electronic device 10 is damaged to cause the data lost, the user can connect the electronic device 10 or the new electronic device with the cable assembly 20 to recover the data within the cable assembly 20 into the electronic device and the data within the electronic device 10 is recovered. The user is not required to input the data again and the convenience is increased.

With reference to FIG. 2, when the data recover is processed in the present invention, the electronic device 10 is connected with the cable assembly 20 and the electronic device 10 executes the application.

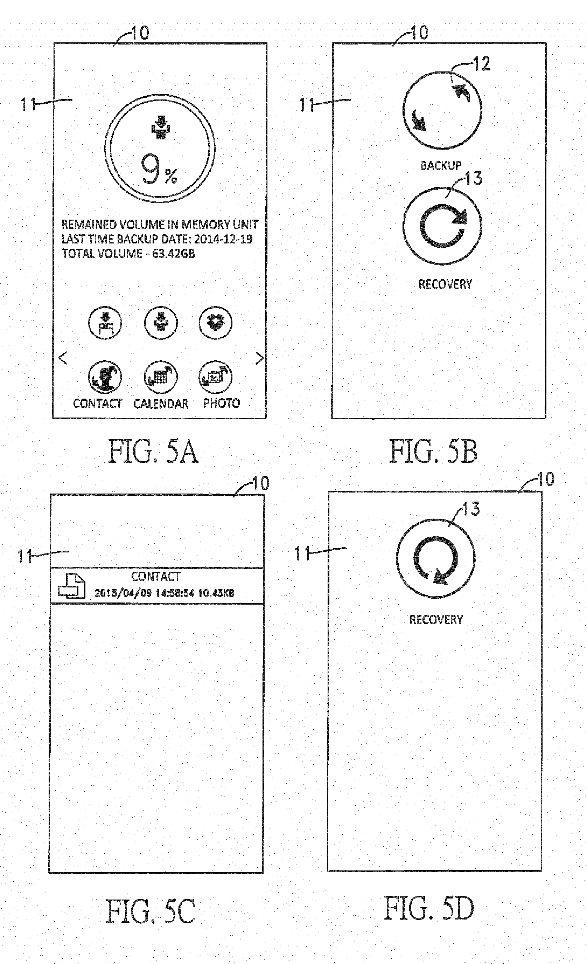

With reference to FIG. 5A, when the electronic device 10 executes the application, the display screen 11 of the electronic device 10 shows the remained volume of the storage in the cable assembly 20 available for the electronic device 10 to back up. If the data recover has been executed before, the previous date of the data recovery will be shown as a reference for the user. The application provides many different kinds of backup functions for the user to choose. For example, the user can choose to back up the data related to contact data, calendar, photo, or any combinations thereof. In other words, the data can be contact data, calendar data, photo data, or any combinations thereof. In the preferred embodiment, the user chooses to back up or recover the contact data.

With reference to FIG. 5B, when the user chooses to back up or recover the contact data, the display screen 11 of the electronic device 10 will show the backup icon 12 and the recover icon 13 for the user to choose that the data within the electronic device will be back up in the cable assembly or the data within the cable assembly will be transferred to recover in the electronic device. When the user chooses the backup icon 13, the electronic device 10 receives the backup signal generated at the time when the user chooses the backup icon 12 and the electronic device 10 confirms whether the electronic device 10 is connected with the cable assembly 20 (step S21). When the electronic device 10 receives the backup signal and the electronic device 10 is confirmed to be connected with the cable assembly 20, the backup procedure can be started to be executed (step S22). If the electronic device 10 didn't receive the recovery signal or the electronic device 10 and the cable assembly 20 are not connected, the electronic device 10 re-confirms whether the backup signal is received or the electronic device 10 and the cable assembly 20 are connected (step S21).

With reference to FIG. 5C, when the backup procedure is executed, the electronic device 10 shows at least one contact data for the user to choose (S23) and the user can choose which contact data is going to be recovered from the cable assembly 20 to the electronic device 10. In the preferred embodiment, the at least one contact data is the contact data which the user backed up from the electronic device 10 to the cable assembly 20. The user repeatedly transfers the contact data from the electronic device 10 to back up in the cable 20 at different time, so more than one contact data in the cable assembly 20 can be chosen for the user and each one of the contact data is developed at different time.

With reference to FIG. 5D, when the user chooses one of the contact data, the electronic device 10 will transfer the contact data saved in the cable assembly 20 by the user back to the electronic device 10 and the contact data is stored in the electronic device (step S23). The electronic device 10 confirms whether the data storing is finished (step S24).

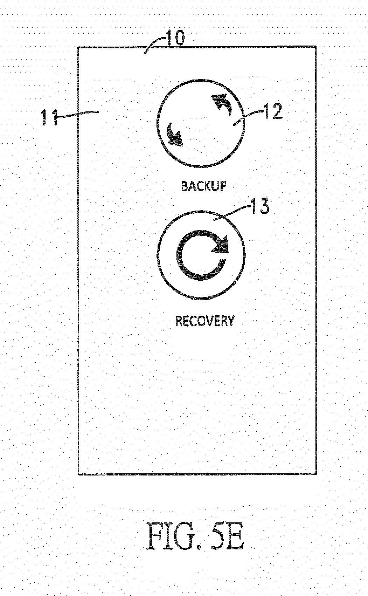

With reference to FIG. 5E, when the data in the cable assembly 20 is completely transmitted to and stored in electronic device 10, the backup procedure is ended (step S25), and the backup icon 12 and the recover icon 13 are shown in the display screen 11 of the electronic device 10. When the data to store in the electronic device 10 is not finished, the step S23 is repeated.

While the present invention has been described in terms of what are presently considered to be the most practical and preferred embodiments, it is to be understood that the present invention need not be restricted to the disclosed embodiment. On the contrary, it is intended to cover various modifications and similar arrangements included within the spirit and scope of the appended claims which are to be accorded with the broadest interpretation so as to encompass all such modifications and similar structures. Therefore, the above description and illustration should not be taken as limiting the scope of the present invention which is defined by the appended claims.

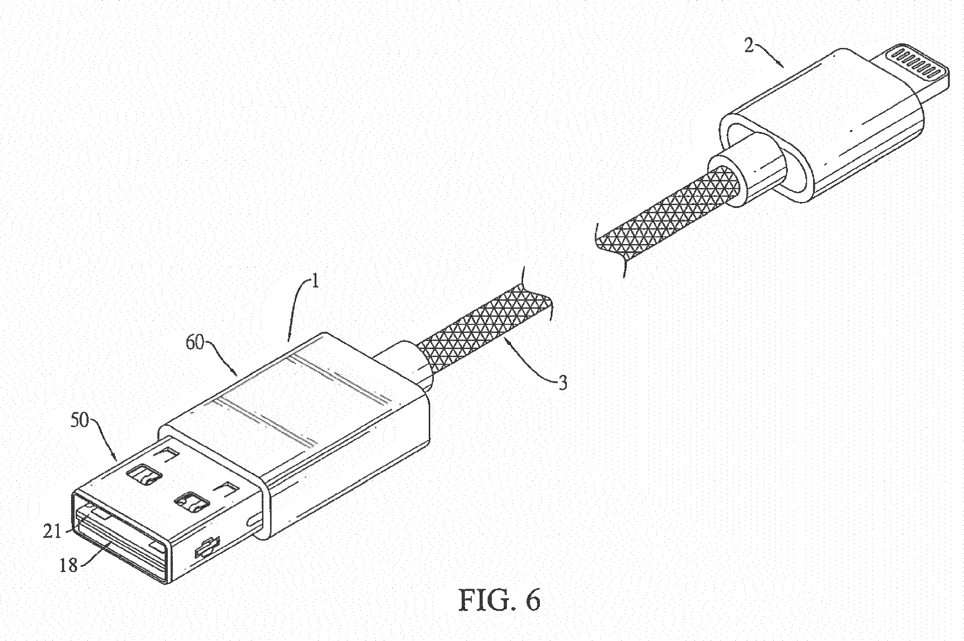

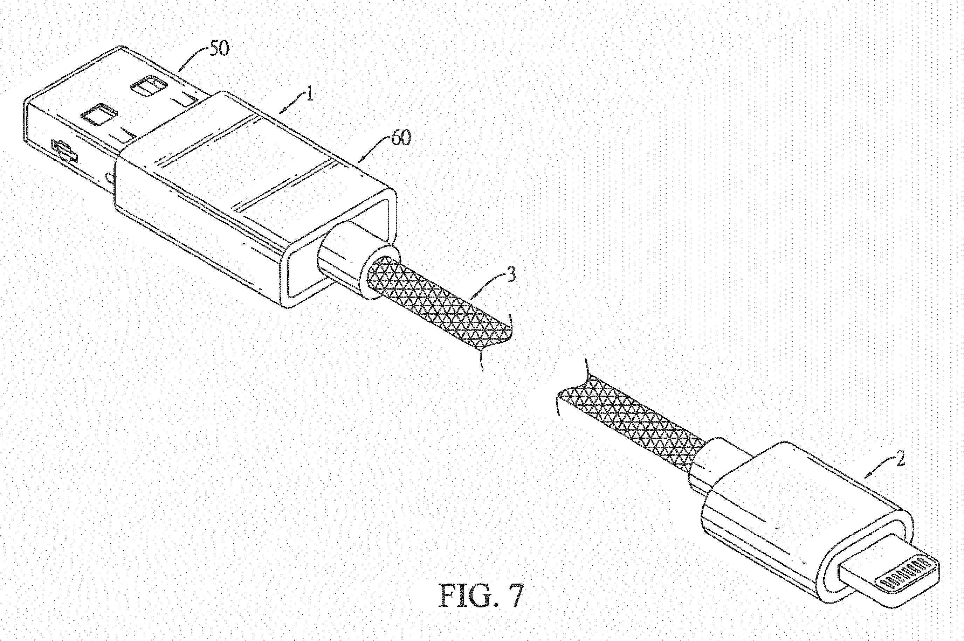

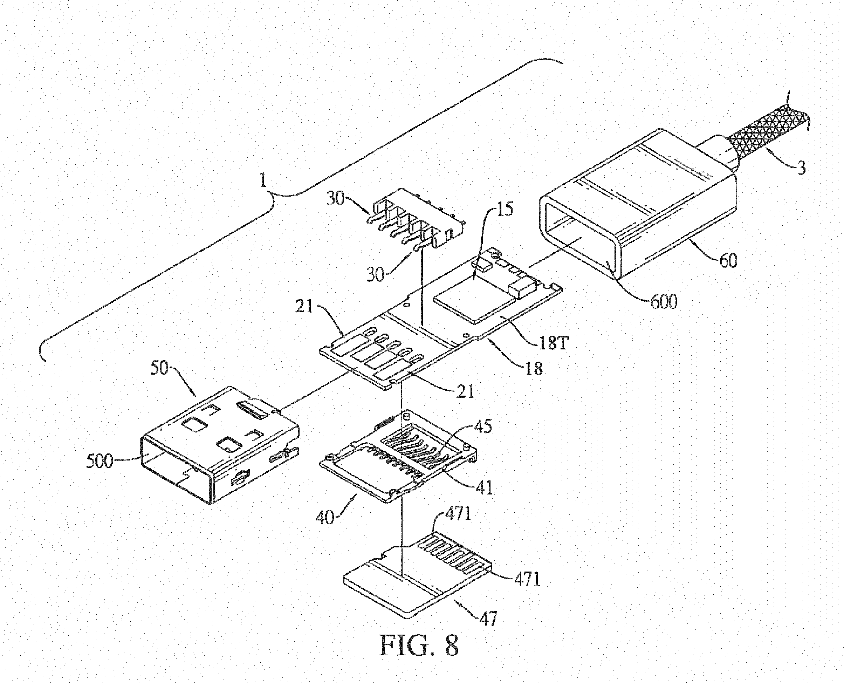

Please refer to Fig.6 to Fig.8. The cable assembly 20 consists of the plug connector 1 of the present invention, a device connector 2 and a cable body 3. The cable body 3 is connected between plug connector 1 and device connector 2. The plug connector 1 includes a circuit board assembly, a memory module 47, a shielded enclosure 50 and a protective shell 60.

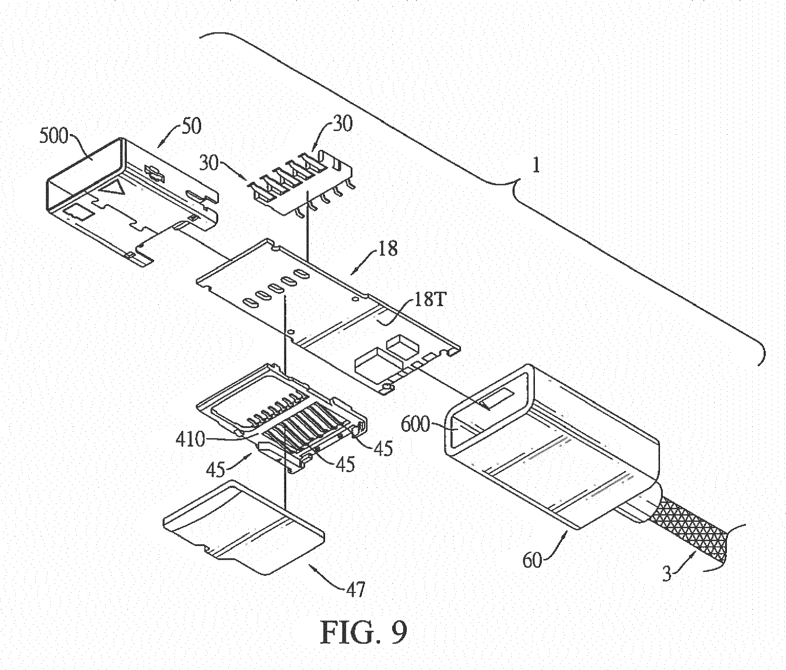

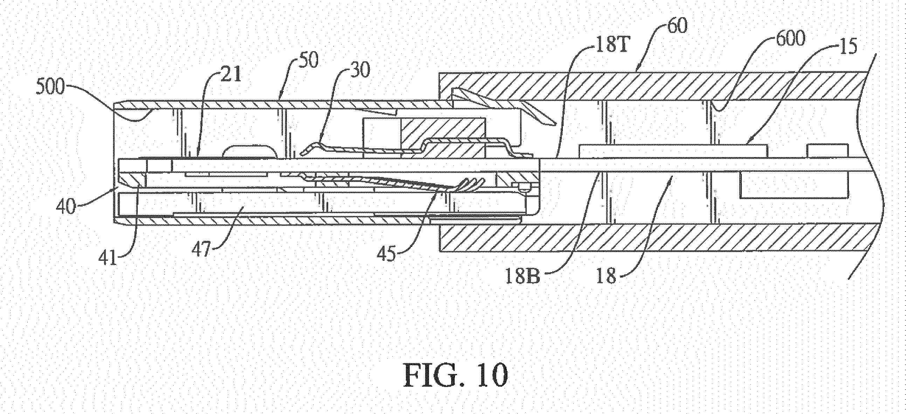

Please further refer to Fig.9 and Fig.10. The circuit board assembly includes a circuit board 18, a first terminal group, and a memory connector 40. The first terminal group including a plurality of first conductive terminals 21 is disposed on the top surface 18T of the circuit board 18 and the first conductive terminals could transmit power. The memory connector 40 is disposed on the bottom surface 18B of the circuit board 18. The memory connector 40 includes a fixed support 41 and a plurality of signal terminals 45. The fixed support 41 is fixed at the bottom surface 18B of the circuit board 18. An assembly groove 410 is on the bottom surface of the fixed support 41. The signal terminals 45 are fixed in the fixed support 41. When the circuit board assembly only has the first terminal group, the plug connector 1 could be designed as meeting universal serial bus 2.0 standards.

The circuit board assembly further includes a second terminal group. The second terminal group including a plurality of second conductive terminals 30 is disposed on the top surface 18T of the circuit board 18. Therefore, the plug connector 1 could be designed as meeting universal serial bus 3.0 standards.

The memory module 47 is micro secure digital card or other small size memory card. The memory module 47 is assembled at the assembly groove 410 of the memory connector 40 in non-removable mode (e.g., using an inserting mode to assemble). The memory module 47 is assembled at the assembly groove 410 of the memory connector in removable mode (e.g., using a welding mode or sticking mode to assemble). Furthermore, a plurality of metal contacts on top surface of the memory module 47 is electrically connected to the signal terminals 45 respectively.

The shielded enclosure 50 includes an accommodating space 500. The accommodating space 500 could contain the circuit board assembly and the memory module 47. The material of the protective shell 60 is rubber or plastic. The protective shell 60 includes a cavity 600 in order to contain the shielded enclosure 50.

With the above-described method, when the plug connector 1 are further assembled into the cable assembly 20, the first conductive terminal 21 of the circuit board assembly transmits electric power into the electronic device 10. The memory module 47 could provide the electronic device 10 an additional storage capacity. The user could move the files of the electronic device 10 into the memory module 47. The electronic device 10 could also read the files of the memory module 47 in order to reduce using the internal memory of the electronic device 10. As a result, the cable assembly 20 could decrease the operating system of the electronic device 10 is in disorder or poor efficiency.

## Claims

1. A data backup method by using a cable assembly with storage function, the data backup method executed by an electronic device and comprising steps of:
determining whether a backup signal is received and a cable assembly with storage function is connected, wherein the cable assembly with storage function is a cable assembly having a flash memory module;
executing a backup procedure when the backup signal is received and the cable assembly is connected;
transmitting data stored in the electronic device to the cable assembly when the backup procedure is executed;
confirming whether the data is completely transmitted to and stored in the cable assembly with storage function; and
ending the backup procedure when the data is stored in the cable assembly with storage function.

2. The data backup method by using a cable assembly with storage function as claimed in claim 1, wherein the data is contact data, calendar data or photo data.

3. A data recovery method by using a cable assembly with storage function and the method executed by an electronic device and comprising steps of:
determining whether a recovery signal is received and a cable assembly with storage function is connected, wherein the cable assembly with storage function is a cable assembly having a flash memory module;
executing a recover procedure when the recovery signal is received and the cable assembly is connected;
choosing one data in the cable assembly with storage function to transmit to the electronic device when the recover procedure is executed;
confirming whether the data is stored in the electronic device; and
ending the recover procedure when the data is stored in the electronic device.

4. The data backup method by using a cable assembly with storage function as claimed in claim 3, wherein the data is contact data, calendar data or photo data.

5. A plug connector comprising:
a circuit board assembly including:
a circuit board;
a first terminal group including a plurality of first conductive terminals to transmit electric power, the first terminal group is disposed on the top surface of the circuit board; and
a memory connector disposed on the bottom surface of the circuit board;
a memory module assembled on the memory connector; and
a shielded enclosure including an accommodating space;
wherein the accommodating space contains the circuit board assembly and the memory module.

6. The plug connector of claim 5, wherein the memory module is assembled at the memory connector in non-removable mode.

7. The plug connector of claim 5, wherein the memory module is assembled at the memory connector in removable mode.

8. The plug connector of claim 5, wherein the memory connector includes a fixed support and a plurality of signal terminals, the fixed support is fixed at the bottom surface of the circuit board, and a assembly groove on the bottom surface of the fixed support contains the memory module, and the signal terminals is fixed in the fixed support; wherein a plurality of metal contacts on top surface of the memory module is electrically connected to the signal terminals respectively.

9. The plug connector of claim 8, wherein the circuit board assembly further includes a second terminal group and the second terminal group including a plurality of second conductive terminals is disposed on the top surface of the circuit board.

10. The plug connector of claim 9 further comprising a protective shell, wherein the protective shell includes a cavity in order to contain the shielded enclosure.

11. The plug connector of claim 10, wherein the plug connector meets universal serial bus 2.0 standards.

12. The plug connector of claim 10, wherein the plug connector meets universal serial bus 3.0 standards.

13. A cable assembly comprising:
a plug connector including:
a circuit board assembly including:
a circuit board;
a first terminal group including a plurality of first conductive terminals to transmit electric power, the first terminal group is disposed on the top surface of the circuit board; and
a memory connector disposed on the bottom surface of the circuit board;
a memory module assembled on the memory connector; and
a shielded enclosure including an accommodating space, wherein the accommodating space contains the circuit board assembly and the memory module;
a device connector; and
a cable body connected between the plug connector and the device connector.
